# FASCICULE DE BREVET EUROPEEN

(11) **EP 1 435 111 B1**
(45) Date de publication et mention de la délivrance du brevet: **08.12.2010**
(21) Numéro de dépôt: 02785528.7
(22) Date de dépôt: 08.10.2002
(51) Int. Cl.: H01L 21/762

(54) **PROCEDE DE FABRICATION DE COUCHES MINCES CONTENANT DES MICROCOMPOSANTS**
VERFAHREN ZUR HERSTELLUNG DÜNNER SCHICHTEN, DIE MIKROKOMPONENTEN ENTHALTEN
METHOD FOR MAKING THIN LAYERS CONTAINING MICROCOMPONENTS

(30) Priorité: 11.10.2001 FR 0113105
(43) Date de publication de la demande: 07.07.2004
(73) Titulaire: Commissariat à l'Énergie Atomique et aux Énergies Alternatives, 75015 Paris (FR); S.O.I.Tec Silicon on Insulator Technologies, 38190 Bernin (FR)
(72) Inventeur: ASPAR, Bernard, F-38140 Rives (FR); LAGAHE, Chrystelle, F-38134 Saint Joseph de Riviére (FR); GHYSELEN, Bruno, F-38170 Seyssinet (FR)
(74) Mandataire: Quantin, Bruno Marie Henri
(86) Numéro de dépôt international: PCT/FR2002/003422
(87) Numéro de publication internationale: WO 2003/032384

(56) Documents cités:
- EP-A- 0 938 129
- FR-A- 2 797 347
- US-A- 6 054 370
- YUN C H ET AL: "Thermal and mechanical separations of silicon layers from hydrogen pattern-implanted wafers" JOURNAL OF ELECTRONIC MATERIALS, AUG. 2001, TMS;IEEE, USA, vol. 30, no. 8, pages 960-964, XP008005517 ISSN: 0361-5235
- YUN C H ET AL: "Fractional implantation area effects on patterned ion-cut silicon layer transfer" SOI CONFERENCE, 1999. PROCEEDINGS. 1999 IEEE INTERNATIONAL ROHNERT PARK, CA, USA 4-7 OCT. 1999, PISCATAWAY, NJ, USA,IEEE, US, 4 octobre 1999 (1999-10-04), pages 129-130, XP010370243 ISBN: 0-7803-5456-7
- PATENT ABSTRACTS OF JAPAN vol. 1999, no. 05, 31 mai 1999 (1999-05-31) -& JP 11 045862 A (DENSO CORP), 16 février 1999 (1999-02-16)
- PATENT ABSTRACTS OF JAPAN vol. 1999, no. 08, 30 juin 1999 (1999-06-30) -& JP 11 074208 A (DENSO CORP), 16 mars 1999 (1999-03-16)

## Description

L'invention concerne la réalisation de microcomposants à partir d'une couche mince sur un substrat, et la réalisation de cet ensemble couche mince/substrat.

Par couche mince, on entend, de façon classique, une couche dont l'épaisseur est habituellement comprise entre quelques dizaines d'angström et plusieurs micromètres. Quant au substrat visé par l'invention, il peut être initial ou intermédiaire, et être « démontable », c'est à dire destiné à être séparé de cette couche mince.

De plus en plus, on souhaite pouvoir réaliser des microcomposants devant être intégrés sur des supports différents de ceux permettant leur fabrication.

Par exemple, on peut citer les microcomposants sur substrats plastiques ou sur substrats souples. Par microcomposants, on entend ici tout dispositif électronique ou optoélectronique, ou tout capteur (par exemple chimique, mécanique, thermique, biologique ou biochimique), réalisé (en anglais, « *processed* ») entièrement ou partiellement.

Pour intégrer ces microcomposants sur des supports souples, on peut utiliser une méthode de report de couche.

Il existe de nombreux autres exemples d'applications où les techniques de report de couche peuvent fournir une solution adaptée pour l'intégration de microcomposants ou de couches sur un support à priori inadapté à leur réalisation. Dans le même esprit, ces techniques de transfert de couches sont également très utiles lorsque l'on souhaite isoler une couche fine, avec ou sans microcomposant, de son substrat initial, par exemple en procédant à une séparation ou élimination de ce dernier. Encore dans le même esprit, un retournement de couche fine associé à son transfert sur un autre support fournit aux ingénieurs un degré de liberté précieux pour pouvoir concevoir des structures impossibles par ailleurs. Ces prélèvements et retournements de films minces permettent par exemple de réaliser des structures dites enterrées telles que des capacités enterrées pour les « DRAM » (initiales des mots anglais « *Dynamic Random Access Memory* », c'est-à-dire « Mémoire vive Dynamique ») où, contrairement au cas usuel, les capacités sont d'abord formées puis reportées sur un autre substrat de silicium avant de reprendre la fabrication sur ce nouveau substrat du reste des circuits. Un autre exemple concerne la réalisation de structures de transistors dites à double grille. La première grille d'un transistor « CMOS » est réalisée selon une technologie conventionnelle sur un substrat, puis reportée avec retournement sur un second substrat pour reprendre la réalisation de la deuxième grille et de la finition du transistor, laissant ainsi la première grille enterrée dans la structure (voir par exemple K. Suzuki, T. Tanaka, Y. Tosaka, H. Horie et T Sugii, « High-Speed and Low-Power n+-p+ Double-Gate SOl CMOS », IEICE Trans. Electron., vol. E78-C, 1995, pages 360 à 367).

Vouloir isoler une couche mince de son substrat initial se rencontre par exemple dans le domaine des diodes électroluminescentes (« *LED* » en anglais), comme il est par exemple reporté dans les documents W.S Wong et al., Journal of Electronic Materials, page 1409, vol. 28, n° 12, 1999, ou I. Pollentier et al., page 1056, SPIE vol. 1361, « Physical Concepts of Materials for Novel Optoelectronic Device Applications I », 1990. Un des buts recherchés ici est un meilleur contrôle de l'extraction de la lumière émise. Un autre but concerne le fait que dans cet exemple particulier, le substrat saphir ayant servi à réaliser l'empilement épitaxial se retrouve a posteriori encombrant, notamment du fait de son caractère électriquement isolant qui empêche toute prise de contact électrique en face arrière. Pouvoir se débarrasser de ce substrat saphir dont l'emploi était avantageux pour la phase de croissance du matériau apparaît donc désormais souhaitable.

On retrouve une situation identique par exemple dans le domaine des applications liées aux télécommunications et hyperfréquence. Dans ce cas, on préfère que les microcomposants soient intégrés en final sur un support présentant une résistivité élevée, typiquement de plusieurs kohm·cm au moins. Mais un substrat fortement résistif n'est pas forcément disponible aux mêmes coûts et qualité que les substrats standard habituellement utilisés. Dans le cas du silicium, on peut par exemple noter la disponibilité de plaques de silicium en diamètres 200 et 300 mm de résistivité standard, tandis que pour des résistivités supérieures à 1 kohm·cm, l'offre est très inadaptée en 200 mm et inexistante en 300 mm. Une solution consiste à réaliser les microcomposants sur substrats standards puis à reporter lors des étapes finales une couche fine contenant les microcomposants sur un substrat isolant tel que le verre, le quartz ou le saphir.

D'un point de vue technique, ces opérations de transfert ont pour intérêt majeur de décorréler les propriétés de la couche dans laquelle sont formés les microcomposants de celles de la couche servant de support final, et sont par conséquent intéressantes dans bien d'autres cas encore.

On peut encore citer les cas où le substrat d'intérêt pour la réalisation des microcomposants coûte excessivement cher. Dans ce cas, par exemple celui du carbure de silicium qui offre de meilleures performances (températures d'utilisation plus élevées, puissances et fréquences maximum d'utilisation significativement améliorées, et ainsi de suite) mais dont le coût est très élevé comparativement au silicium, on aurait intérêt à transférer une couche fine du substrat cher (le carbure de silicium ici) sur le substrat bon marché (le silicium ici), et à récupérer le résidu du substrat cher pour une réutilisation après éventuellement une opération de recyclage. L'opération de transfert peut avoir lieu avant, au cours ou après la réalisation des microcomposants.

Ces techniques peuvent également trouver leur intérêt dans tous les domaines où obtenir un substrat mince est important pour l'application finale. En particulier, on peut citer les applications de puissance, pour des raisons liées à l'évacuation de chaleur (qui sera d'autant meilleure que le substrat est fin) ou parce que le courant électrique doit parfois traverser l'épaisseur des substrats, avec des pertes qui sont en première approximation proportionnelles à l'épaisseur traversée par ce courant. On peut aussi citer les applications de carte à puce pour lesquelles une finesse des substrats est recherchée pour des raisons de souplesse. De même, on peut citer les applications destinées à la réalisation de circuits 3D ainsi que d'empilements de structures.

Pour toutes ces applications (citées à titre d'exemples), la réalisation de circuits est faite sur des substrats épais ou d'épaisseur standard, avec pour avantages, d'une part, de bien supporter mécaniquement les différentes étapes technologiques, et d'autre part de répondre aux normes concernant leur passage sur certains équipements de production. Il est donc nécessaire de réaliser un amincissement pour conduire à l'application finale.

Différentes techniques peuvent être utilisées pour reporter des couches d'un support vers un autre support. On peut citer par exemple les techniques publiées en 1985 par T. Hamaguchi et al., Proc. IEDM 1985, p. 688. Ces techniques présentent un grand intérêt puisqu'elles permettent effectivement de transférer une couche d'un substrat vers un autre substrat ; mais elles nécessitent la consommation du substrat de base (détruit au cours du procédé), et ne permettent pas le transfert homogène d'un film mince sauf si une couche d'arrêt (c'est à dire une couche formant une inhomogénéité dans la matière du substrat) est présente.

Parmi les procédés connus de report permettant de récupérer le film mince après transfert, il est également possible d'utiliser des méthodes de transfert de couches minces de matériaux contenant (ou pas) tout ou partie d'un microcomposant. Ces méthodes sont fondées pour certaines d'entre elles sur la création dans un matériau d'une couche fragile enterrée, à partir de l'introduction d'une ou plusieurs espèces gazeuses. On peut à ce propos se référer aux documents US-A-5374564 (ou EP-A-533551), US-A-6020252 (ou EP-A-807970), FR-A-2767416 (ou EP-A-1010198), FR-A-2748850 (ou EP-A-902843), ou FR-A-2773261 (ou EP-A-963598), qui présentent ces procédés. Ceux-ci sont généralement utilisés avec l'objectif de détacher l'ensemble d'un film d'un substrat initial pour le reporter sur un support. Le film mince obtenu peut contenir alors une partie du substrat initial. Ces films peuvent servir de couches actives pour la réalisation de microcomposants électroniques ou optiques.

Ces méthodes permettent en particulier la réutilisation du substrat après séparation, ces substrats ne se consommant que très peu ainsi à chaque cycle. En effet, l'épaisseur prélevée n'est fréquemment que de quelques microns tandis que les épaisseurs de substrat sont typiquement de plusieurs centaines de microns. On peut ainsi obtenir, en particulier dans le cas du procédé divulgué dans le document US-A-6020252 (ou EP-A-807970), des substrats qui sont assimilables à des substrats « démontables » (c'est à dire des substrats détachables) à l'aide d'une contrainte mécanique. Ce procédé particulier repose sur la formation par implantation d'une zone enterrée fragilisée selon laquelle se réalisera la découpe lors du transfert final.

D'autres méthodes, basées sur le principe dit du « *lift-off*»*,* permettent également de séparer une couche mince du reste de son support initial, ici aussi sans nécessairement consommer ce dernier. Ces méthodes utilisent généralement des attaques chimiques, associées ou non à des efforts mécaniques, attaquant sélectivement une couche intermédiaire enterrée. Ce type de méthode est très utilisé pour le report d'éléments III-V sur différents types de supports (cf. C. Camperi et al., IEEE Transaction and Photonics Technology, vol. 3 n° 12, 1991, page 1123). Comme il est expliqué dans l'article de P. Demeester et al., Semicond. Sci. Technol. 8, 1993, pages 1124 à 1135, le report, ayant lieu généralement après une étape d'épitaxie, peut être réalisé avant ou après la réalisation des microcomposants (« *pre-processing* » ou « *post-processing* » en anglais, respectivement).

Parmi les méthodes utilisant la présence d'une couche enterrée (préexistante) de tenue mécanique plus faible que le reste du substrat pour obtenir une séparation localisée au niveau de cette couche enterrée, on peut citer le procédé ELTRAN^{®} (Japanese Patent Publication Number 07302889). Dans ce cas, un empilement à base de silicium monocristallin est fragilisé localement grâce à la formation d'une zone de silicium poreux. Un autre cas similaire consiste à tirer profit de la présence d'un oxyde enterré dans le cas d'une structure «SOI» (initiales des mots anglais « *Silicon On Insulator* », c'est-à-dire « Silicium sur Isolant ») aussi classique soit-elle (c'est à dire réalisée sans rechercher un effet démontable particulier). Si cette structure est collée de manière suffisamment forte sur un autre substrat et si l'on exerce une contrainte importante sur la structure, on peut obtenir une fracture localisée préférentiellement dans l'oxyde, menant à une découpe à l'échelle du substrat entier. Le document PHILIPS Journal of Research, vol. 49 n° 1/2, 1995, en montre un exemple en pages 53 à 55. Malheureusement, cette fracture est difficilement contrôlable et elle nécessite des contraintes mécaniques importantes, ce qui n'est pas sans risque de casse des substrats ou de détérioration concernant les microcomposants.

L'avantage de tels procédés à couche fragile enterrée est de pouvoir réaliser des couches à base de matériaux cristallins (Si, SiC, InP, AsGa, LiNbO₃, LiTaO₃, et ainsi de suite) dans une gamme d'épaisseurs pouvant aller de quelques dizaines d'angstrôm (A) à plusieurs micromètres (µm), avec une très bonne homogénéité. Des épaisseurs plus élevées restent également accessibles.

Les techniques de transfert de couches (avec ou sans microcomposant) reposant sur la réalisation de substrats démontables par formation d'une couche intermédiaire ou interface fragilisée (qu'elle soit obtenue par fragilisation par implantation d'espèces, par formation d'une zone poreuse, ou par un autre moyen) se heurtent à cet égard à certains problèmes liés à un délaminage intempestif lorsque les traitements préalables à la séparation volontaire sont trop agressifs.

L'invention a pour objet de combiner de façon fiable l'impératif de séparation aisée, le moment voulu, et l'impératif de pouvoir, le cas échéant, supporter l'application de traitements thermiques ou mécaniques nécessaires pour la réalisation de tout ou partie de microcomposants électroniques, optiques, acoustiques ou de capteurs, ou encore d'étapes d'épitaxie, sans provoquer de délaminage ou de séparation prématurée.

Plus généralement, l'invention a pour objet un ensemble comportant une couche mince sur un substrat, cette couche étant reliée à ce substrat par une interface ou une couche intermédiaire présentant un niveau de tenue mécanique facile à contrôler.

Un tel substrat démontable peut être élaboré, selon le document FR 2748851, par introduction d'une espèce gazeuse (par exemple l'hydrogène). La dose implantée doit être choisie de telle sorte qu'un recuit thermique n'induise pas de déformation ou d'exfoliation de surface. Selon les forces mécaniques applicables et/ou l'outil utilisé pour induire la séparation entre la couche superficielle et le reste du substrat, le stade de fragilisation atteint au niveau de la zone implantée peut se révéler insuffisant. Il peut alors être intéressant d'augmenter la fragilisation de la zone implantée.

Le procédé décrit dans le document FR 2773261 permet également de réaliser un substrat démontable, grâce à la présence d'une couche enterrée d'inclusions utilisée comme couche de piégeage dans le substrat. Celle-ci permet, après différents traitements, par exemple d'élaboration de microcomposants électroniques, de localiser, préférentiellement au niveau de cette couche de piégeage, et en quantité suffisante, des espèces gazeuses qui pourront contribuer à la séparation finale de la couche mince superficielle délimitée par la zone d'inclusions et la surface du substrat. Cette étape de séparation peut comprendre un traitement thermique et/ou l'application d'une contrainte mécanique à la structure.

L'utilisation de cette technique peut rencontrer des limitations, notamment en ce qui concerne la réintroduction d'espèces gazeuses dans la couche superficielle après la fabrication de tout ou partie des microcomposants, qui peut être indésirable pour certains types de microcomposants réalisés.

D'après le procédé divulgué dans la demande française n° 0006909, l'introduction d'une dose contrôlée d'espèces implantées permet à la fois de fragiliser (voire surfragiliser) la zone enterrée et d'évacuer ensuite le gaz, cela afin de limiter un effet de pression lors d'une montée en température. On n'a donc pas de déformation ou d'exfoliation de la surface lors d'étapes technologiques à hautes températures. Cette technique nécessite un contrôle rigoureux des conditions d'implantation (doses, températures, et ainsi de suite). Il peut donc se révéler intéressant de pouvoir relâcher les contraintes relatives à une fenêtre technologique étroite.

Le document FR 2758907 propose une introduction locale d'espèces gazeuses après élaboration des microcomposants dans la couche superficielle du substrat. L'introduction de ces espèces mène à la formation d'une couche enterrée discontinue de microcavités susceptibles de contribuer à la fracture après solidarisation du substrat traité sur un substrat support. Le substrat est donc fragilisé après la réalisation des différentes étapes technologiques de fabrication des microcomposants. La taille accessible des zones à masquer (qui correspondent aux zones actives des microcomposants) peut se révéler limitative selon les applications visées. Par exemple, pour des tailles de microcomposants de plusieurs dizaines à plusieurs centaines de microns, cette technique est difficile à mettre en oeuvre. De plus, selon la technologie d'élaboration des microcomposants utilisée, l'épaisseur de la couche active, c'est-à-dire comportant les microcomposants, peut atteindre plusieurs microns. L'introduction des espèces gazeuses à une forte profondeur (par implanteurs spécifiques, ou par accélérateurs) peut alors s'avérer délicate, tout en protégeant efficacement les zones par masquage.

L'article "Fractional Implantation Area Effects on Patterned lon-Cut Silicon Layer Transfer" de C.H. Yun et N.W. Cheung (conférence SOI de 1999) est une étude de laboratoire dans laquelle on implante des ions H⁺ dans un substrat source en silicium à travers un masque, puis on réalise un recuit rapide de manière à produire le clivage d'une couche mince à la surface du substrat source. Le procédé décrit la fabrication de composants MOS lors d'une étape préalable à l'implantation gazeuse. Le masque est destiné à protéger les zones diélectriques de grille de ces composants.

Le document US 6 054 370 décrit un procédé de réalisation de microcomposants dans lequel : 1) on applique à l'aide de masques une première implantation fragilisante uniquement dans des premières zones situées précisément sous les zones dans lesquelles on prévoit de réaliser des microcomposants ; 2) on réalise ces microcomposants ; 3) on applique une seconde implantation fragilisante entre les microcomposants protégés par des masques, de manière fragiliser les secondes zones situées entre les premières zones ; et 4) on sépare la couche mince du substrat.

Afin de remédier aux inconvénients présentés ci-dessus, l'invention propose un procédé de fabrication, au moyen d'un substrat, de couches minces contenant des microcomposants, comprenant, pour chacune de ces couches minces, les étapes suivantes dans cet ordre :
a) l'implantation localisée d'au moins une espèce gazeuse dans ledit substrat au droit d'une pluralité de zones d'implantation gazeuse définies à la surface du substrat, de manière à créer une pluralité de zones fragiles enterrées au voisinage de la profondeur d'implantation gazeuse,
b) la réalisation de microcomposants dans la couche superficielle du substrat délimitée par lesdites zones fragiles enterrées, et
c) le détachement de ladite couche superficielle du reste du substrat,
   **caractérisé en ce que** ladite profondeur d'implantation et la géométrie desdites zones d'implantation gazeuse sont telles que l'étape b) est réalisée sans dégradation de la surface du substrat, et en ce que au moins un desdits microcomposants est réalisé au moins partiellement au droit d'une zone qui n'a pas été implantée lors de l'étape a).

Par « dégradation », on entend ici toute déformation de surface (sous forme par exemple de cloques) ou toute exfoliation de la couche superficielle, qui seraient préjudiciables à la bonne réalisation de l'étape b).

Ainsi, selon l'invention, on prévoit des zones protégées de l'implantation et des zones subissant l'implantation desdites espèces gazeuses, les formes, les dimensions et la répartition de ces zones d'implantation étant choisies de manière à empêcher toute déformation de la surface du substrat d'une amplitude supérieure, disons, à quelques dizaines d'angstrôm, lors de l'étape de réalisation des microcomposants. Notamment, on tiendra compte à cet effet de la rigidité de la couche superficielle (qui peut éventuellement être constituée par un empilement de plusieurs couches de matériaux), des conditions d'implantation, et des traitements ultérieurs jusqu'à la séparation de ladite couche mince.

Le procédé selon l'invention permet de réaliser un substrat démontable comportant des zones enterrées fragilisées par la présence de microcavités et/ou microfissures (séparant ainsi localement la couche superficielle du reste du substrat), et des zones non ou peu fragilisées permettant de maintenir la couche superficielle solidaire du substrat. On obtient ainsi des zones localisées au niveau desquelles la couche superficielle se séparera facilement du substrat du fait de la présence, au niveau de ces zones, de ces microcavités et/ou microfissures.

Un avantage important de l'invention est que le confinement latéral de ces zones enterrées fragilisées permet d'éviter une déformation conséquente de la couche superficielle sous forme de cloque ou d'exfoliation. La fenêtre technologique des doses implantées est élargie par rapport aux procédés selon l'art antérieur, car l'implantation localisée dans des zones confinées permet de limiter l'extension latérale des microfissures.

De plus, la surface du substrat obtenu est compatible avec des étapes technologiques classiques, telles que des opérations de lithographie ou l'élaboration de microcomposants. Notamment, le substrat fragilisé obtenu est compatible avec des traitements à haute température, tels que par exemple une oxydation thermique ou une épitaxie en phase gazeuse ou liquide.

Après réalisation de ces étapes technologiques variées, la présence de zones séparant localement la couche superficielle du substrat va permettre d'obtenir une fracture en profondeur entre cette couche superficielle et le substrat.

Lesdites zones d'implantation pourront commodément être réalisées en tant qu'ouvertures définies dans un masque placé à la surface du substrat.

Lesdites espèces gazeuses pourront par exemple être constituées par des ions hydrogène, ou par des ions d'au moins un gaz rare, ou par un mélange de ces ions.

On notera que le procédé de fabrication selon l'invention pourra comprendre, avant l'étape a), une étape supplémentaire d'introduction d'au moins une espèce gazeuse, cette au moins une introduction supplémentaire étant effectuée en l'absence de masque à la surface du substrat. Par « introduction », on entend, ici et plus bas, des techniques classiques telles que, par exemple, l'implantation ionique, la diffusion activée thermiquement ou encore la diffusion plasma. Un substrat qui a été traité par une introduction supplémentaire avant une implantation selon l'étape a) sera considéré comme un substrat auquel s'applique le procédé selon l'invention tel que décrit succinctement ci-dessus.

Selon des caractéristiques préférées, une telle introduction supplémentaire en l'absence de masquage sur le substrat peut être réalisée entre les étapes a) et b).

Grâce à ces dispositions, on obtient une zone enterrée délimitant une couche superficielle plus ou moins fragilisée puisque certaines zones ont subi, par exemple, deux implantations, alors que d'autres zones n'en ont subi qu'une seule. Les doses d'ions introduits lors de ces implantations peuvent être telles que leur somme corresponde à une dose moyenne causant, dans le cas d'une implantation sur toute la surface du substrat, l'apparition de cloques après traitement thermique. Rappelons que la géométrie des zones ayant subi la double implantation permet d'éviter l'apparition de ces cloques et donc la dégradation de la surface du substrat. Cette variante de réalisation peut notamment être favorable lors de l'étape de séparation de la couche superficielle du reste du substrat (étape c)), et permettre des traitements moins contraignants pour obtenir cette séparation.

Selon d'autres caractéristiques préférées, le procédé de fabrication selon l'invention comprend, avant ou au cours de l'étape b), une étape au cours de laquelle on surfragilise la zone implantée, par exemple par la réalisation de traitements thermiques adaptés ou de dépôts de couches minces particulières induisant des contraintes mécaniques. Par « surfragilisation », on entend ici un état de fragilisation plus important de la zone implantée, de manière à permettre de diminuer les contraintes à mettre en jeu lors de la séparation finale.

Grâce à cette disposition, les défauts structurels engendrés par implantation des espèces gazeuses vont croître au niveau des zones implantées, ce qui aura pour effet d'augmenter la fragilité de ces zones enterrées locales. Le choix judicieux des dimensions des motifs d'implantation peut permettre d'atteindre un seuil de fragilisation important de ces zones, sans pour autant causer de déformation de surface conséquente ni d'exfoliation.

Il est à noter que les étapes optionnelles de surfragilisation des zones implantées peuvent être entièrement ou en partie réalisées lors des étapes de fabrication des microcomposants, pourvu que les séquences de température et de durée soient judicieusement choisies.

Selon d'autres caractéristiques préférées, le procédé de fabrication selon l'invention comprend, entre l'étape b) et l'étape c), une étape supplémentaire d'introduction d'au moins une espèce gazeuse. Cette introduction supplémentaire d'au moins une espèce gazeuse peut par exemple être effectuée à l'aide d'un masque définissant des zones d'implantation de cette au moins une espèce gazeuse.

Grâce à cette disposition, on fragilise la zone enterrée, dans le but de faciliter la désolidarisation ultérieure entre la couche superficielle et le substrat.

Cette désolidarisation (étape c)) pourra être effectuée au moyen d'un traitement thermique et/ou l'application de contraintes mécaniques.

Selon un autre aspect de l'invention, celle-ci concerne une couche mince contenant des microcomposants, ladite couche mince étant remarquable en ce qu'elle a été fabriquée au moyen de l'un quelconque des procédés succinctement décrits ci-dessus. Cette couche sera au besoin reportée sur un support, qui pourra être souple ou rigide.

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés, dans lesquels :
- la figure 1 est une vue schématique d'un substrat muni de moyens de masquage,
- la figure 2 illustre la première étape d'un procédé de fabrication de couches selon l'invention,
- la figure 3 est une vue schématique du substrat après l'enlèvement du masque selon l'invention,
- la figure 4 est une vue schématique du substrat après une deuxième étape d'un procédé de fabrication de couches selon l'invention,
- la figure 5 illustre le report individuel d'un microcomposant sur un substrat support,
- la figure 6 illustre le report sur un support « poignée » d'une couche selon l'invention contenant des microcomposants, et
- la figure 7 illustre le report individuel d'un microcomposant sur un support final à partir d'un support « poignée ».

Nous allons décrire les étapes principales de la fabrication d'une couche selon un mode de réalisation de l'invention.

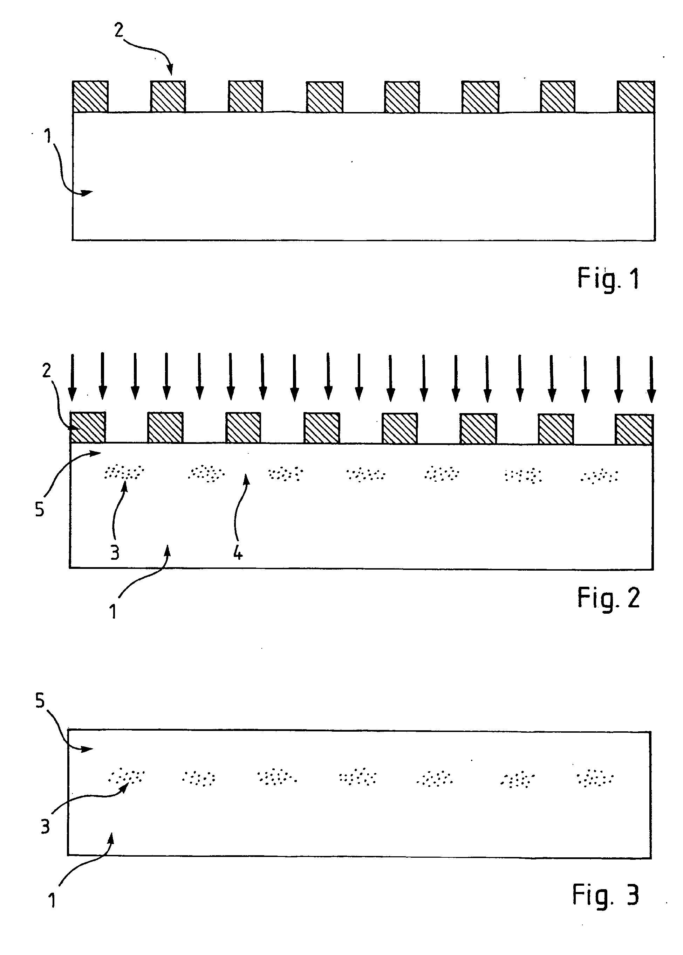

La figure 1 montre la préparation initiale d'un substrat 1. Cette préparation consiste à définir les zones à implanter par réalisation d'un masque 2 délimitant, à la surface d'un substrat 1, des zones non masquées (qui seront ultérieurement implantées) et des zones masquées (qui ne verront pas d'implantation).

Ce masque peut être réalisé au niveau du substrat 1 par une couche de résine à partir d'une étape de lithographie, ou par toute autre couche en surface du substrat 1 (par exemple de l'oxyde) à partir d'étapes successives de lithographie et gravure. Le masquage peut également être effectué à partir d'une grille disposée au niveau de la surface du substrat 1 lors de l'étape d'implantation. Cette grille de masquage peut encore être disposée au niveau d'un diaphragme intercalé entre le faisceau d'ions à implanter et le substrat cible. Ces moyens de masquage ont été décrits à titre d'exemples, mais d'autres moyens de masquage adaptés sont possibles.

Un choix judicieux des formes et des dimensions des zones masquées est primordial pour la bonne réalisation des étapes suivantes. En effet, l'étape d'implantation a pour conséquence de créer une zone enterrée discontinue comportant des défauts spécifiques dus à l'introduction des ions (« platelets », microcavités et/ou microbulles). L'étape de définition des zones à implanter tient compte des propriétés du substrat, des propriétés de la ou des couches de composition ou de matériau différents présentes à la surface du substrat 1, ainsi que des conditions d'implantation.

Les propriétés de rigidité et l'épaisseur de la couche superficielle que l'on cherche à réaliser vont conditionner les dimensions et l'espacement des zones à implanter. Celles-ci seront établies de sorte que la croissance des microcavités et microfissures au niveau des zones implantées, qui pourrait se produire lors de traitements thermiques par exemple, ne mènent :
- ni à une relaxation verticale de la couche superficielle, par formation de cloques, d'amplitude supérieure à quelques dizaines d'angström,
- ni à une interaction totale ou partielle entre différentes zones localement implantées de nature à causer le soulèvement ou l'exfoliation de tout ou partie de la couche superficielle.

Il est ainsi possible de maintenir la surface de la couche superficielle exempte de toute dégradation conséquente, avec des zones enterrées localement fragilisées.

Selon le type de masquage effectué (masque d'oxyde sur le substrat, grille disposée à la surface du substrat au cours de l'implantation, ou encore grille disposée sur le chemin du faisceau d'ions au cours de l'implantation), les dimensions latérales (dans le plan de la surface du substrat) effectives des zones enterrées ayant subi l'implantation ionique sont dépendantes des profils gaussiens d'implantation. Cela signifie qu'un flanc abrupt de masque en surface n'est pas rigoureusement restitué au niveau de la couche enterrée implantée. La dispersion des ions lors de leur pénétration dans le matériau induit un élargissement sensible de la zone implantée. Il est donc nécessaire de tenir compte de ce phénomène pour définir correctement les dimensions des zones masquées et non masquées.

En revanche, les dimensions des zones implantées doivent être suffisantes pour permettre une séparation aisée de la couche superficielle en fin de procédé.

Les essais réalisés par les inventeurs ont montré que, généralement, la surface totale des zones d'implantation représentera, approximativement, entre 1/3 et 5/6 de la surface du substrat 1. De plus, une dimension linéaire des zones d'implantation sera de préférence comprise, approximativement, entre 0,1 et 10 fois l'épaisseur visée pour la couche superficielle, dans le cas d'un substrat en silicium. Dans le cas d'un matériau plus rigide, cette dimension pourra être notablement plus grande, par exemple de l'ordre de 50 fois.

On pourra par exemple utiliser un masque d'implantation comportant des motifs par exemple carrés, ouverts sur 10 µm x 10 µm, séparés par des zones masquées, par exemple, de 5 µm. Comme autre exemple, on pourra utiliser un masque d'implantation comportant des zones non masquées de type lignes dont les dimensions sont, par exemple, de 5 µm X 100 µm, les lignes étant espacées l'une de l'autre de, par exemple, 5 µm.

La première étape de ce mode de réalisation, illustrée sur la **figure 2**, consiste donc à introduire au moins une espèce gazeuse telle que l'hydrogène et/ou un gaz rare sous forme ionique dans le substrat 1.

Le substrat 1 présente en conséquence un ensemble de zones enterrées 3 ayant subi une implantation d'espèces gazeuses, ces zones 3 étant séparées entre elles par des zones 4 dans lesquelles le masquage initial a empêché l'introduction d'espèces gazeuses. Ainsi, le substrat 1 comprend une couche enterrée discontinue composée de défauts 3 tels que des « platelets », microcavités, microbulles ou microfissures. Le confinement latéral des microfissures 3 empêche que leur extension ou leur relaxation ne causent de dégradation de la surface du substrat 1.

L'énergie d'implantation des espèces gazeuses contrôle l'épaisseur de la couche superficielle 5 délimitée par la couche implantée et la surface du substrat 1.

Un exemple d'application peut être une implantation en ions hydrogène à une énergie comprise entre 150 et 250 keV et à une dose comprise entre 10¹⁶ et 10¹⁷ H⁺/cm² environ.

Le masque est ensuite retiré laissant ainsi la surface du substrat 1 entièrement à nu, comme le montre la **figure 3**.

Selon une variante du procédé selon l'invention, on effectue alors une seconde implantation d'ions de même espèce ou d'espèces différentes de la première implantation : les motifs initialement ouverts du masque subissent donc une deuxième implantation alors que les motifs initialement masqués voient une première implantation. Cette seconde implantation va augmenter la densité et/ou la taille des défauts présents dans les zones précédemment implantées, et va de plus induire la formation de défauts enterrés au niveau des zones précédemment masquées. La dose introduite lors de la seconde implantation doit être assez faible, c'est-à-dire qu'elle ne doit pas permettre la formation de cloques et d'exfoliations après un recuit à température moyenne (entre 450°C et 600°C environ). On pourra par exemple de préférence opérer à une énergie de 180 keV et à une dose de 4·10¹⁶ H⁺/cm².

Il existe alors en profondeur une zone enterrée comprenant une quantité plus ou moins importante d'espèces gazeuses et par là même une densité plus ou moins importante de défauts de type microcavités. Les zones ayant subi uniquement la seconde implantation atteindront donc un niveau plus faible de fragilisation que les motifs doublement implantés, mais permettront d'établir la continuité de la zone enterrée fragile.

Le développement des zones fragiles 3 créées par une ou plusieurs implantations d'espèces gazeuses, telles que décrites ci-dessus, dépend des conditions d'implantation, ainsi que d'éventuels traitements effectués après implantation. Ces traitements optionnels visent à surfragiliser les zones locales implantées 3, et à induire la croissance des microcavités présentes dans ces zones. Pour ce faire, on pourra par exemple appliquer un traitement thermique à une température de l'ordre de 450 à 475°C pendant quelques minutes.

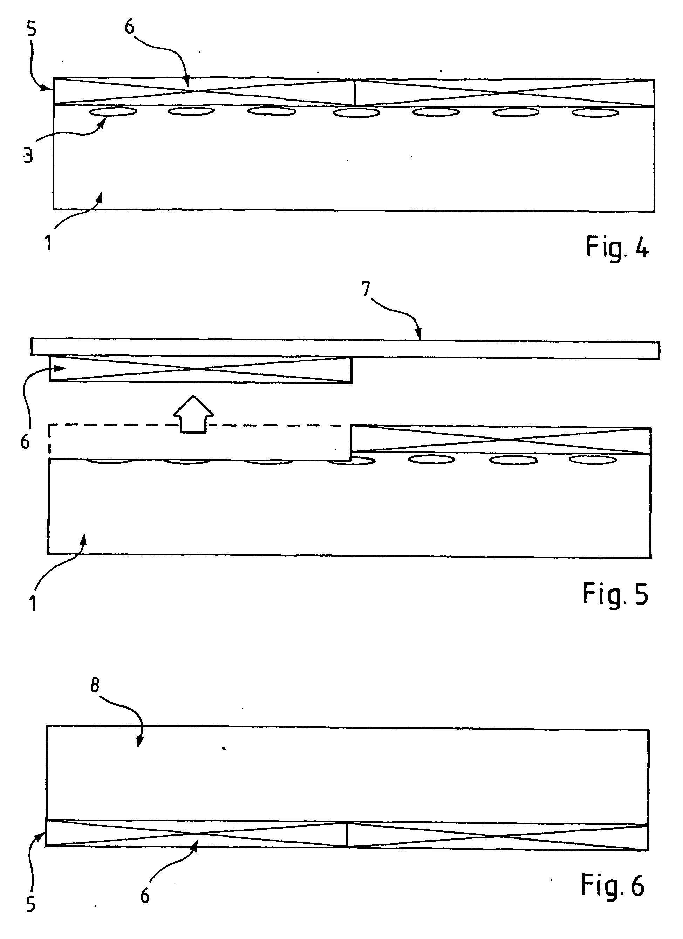

Le substrat ainsi fragilisé peut alors, au cours d'une deuxième étape de ce mode de réalisation de l'invention représentée sur la **figure 4**, subir des traitements thermiques, des étapes de dépôt, d'épitaxie, ou autres traitements d'élaboration de microcomposants électroniques et/ou optiques et/ou de capteurs 6, sans risque de dégradation de la surface.

Le substrat peut ainsi, le cas échéant, être soumis à des opérations d'épitaxie. Une couche épitaxiée de 5 µm permettra par exemple l'élaboration de microcomposants de type « CMOS » au moyen de techniques classiques. Une couche épitaxiée de 50 µm pourra par exemple être utilisée pour la réalisation de cellules photovoltaïques.

La troisième et dernière étape de ce mode de réalisation de l'invention consiste en la séparation entre la couche superficielle 5 contenant les microcomposants 6, et le reste du substrat 1. Selon les conditions dans lesquelles on a mis en oeuvre les deux premières étapes, cette séparation peut être réalisée soit au moyen de traitements thermiques, soit par l'application judicieuse de contraintes mécaniques à la structure, soit encore par combinaison des traitements thermiques et des contraintes mécaniques.

Selon une variante de l'invention, avant de procéder à cette séparation, on pourra effectuer une introduction locale supplémentaire d'au moins une espèce gazeuse au droit de zones identiques aux zones d'implantation utilisées pour la première étape de ce mode de réalisation ou différentes de ces zones, dans le but de faciliter la désolidarisation ultérieure entre la couche superficielle et le substrat.

On pourra effectuer cet ajout d'espèces gazeuses par implantation au niveau des zones déjà fragilisées, ou bien constituer une zone enterrée fragilisée continue en effectuant une implantation au droit de zones initialement masquées au-dessous desquelles le substrat est peu fragilisé ou ne l'est pas du tout. L'énergie d'implantation sera alors choisie de sorte que les espèces implantées atteignent la profondeur des zones fragilisées par les étapes initiales d'implantation, en prenant en compte les changements d'épaisseur intervenus lors de l'élaboration des microcomposants sur la couche 5.

On implantera de préférence une dose de l'ordre de 6.10¹⁶ ions H⁺/cm², dose moyenne permettant l'obtention de la séparation pour un traitement thermique à une température comprise entre 400 et 500°C.

Notons que les conditions de mise en oeuvre de cette variante dépendent:
- de la taille des microcomposants (on peut avoir besoin d'éviter la traversée de zones actives des microcomposants par les ions implantés), et/ou
- de la sensibilité des microcomposants réalisés à une implantation ionique quelle que soit leur taille, si les microcomposants ne sont pas détériorés par la traversée d'ions ou si tout au moins certaines parties des microcomposants n'y sont pas sensibles.

En particulier, pour réaliser cette implantation supplémentaire, on pourra utiliser un masquage adapté, qui pourra bien sûr être différent du masquage utilisé lors de la première étape de ce mode de réalisation.

L'étape de séparation entre la couche superficielle 5 contenant les microcomposants 6, et le reste du substrat 1 peut comporter un traitement thermique (four, et/ou chauffage local, et/ou faisceau laser, ou autre), et/ou l'application de contraintes mécaniques telles que la projection d'un jet de fluide (gaz, liquide) et/ou l'insertion d'une lame au niveau de la zone fragilisée, et/ou des contraintes en traction, cisaillement ou flexion appliquées au substrat 1. A titre d'exemple, on pourra appliquer un traitement thermique à environ 450°C pendant 30 minutes pour séparer la couche superficielle 5 du substrat initial.

Cette séparation peut donner lieu à l'obtention d'une couche autoportée, ou encore au report de la couche superficielle 5 sur un substrat support 7, par exemple par la technique de collage par adhésion moléculaire ou le collage par l'intermédiaire de substances adhésives. La présence de ce support 7 permettra de rigidifier la couche 5 transférée du substrat fragilisé, notamment pour des étapes de transport et/ou de finition.

De plus, comme le montre la **figure 5**, une préparation préalable du substrat démontable peut être faite qui permettra de prélever chaque microcomposant 6 individuellement. Cette technique est d'ailleurs connue d'après la demande FR 2781925.

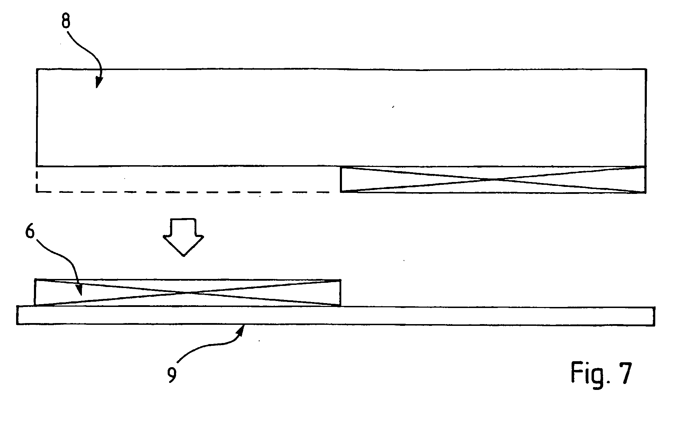

Une variante de l'étape de report sur le support définitif peut comprendre une étape intermédiaire de report de la couche superficielle 5 du substrat fragilisé sur un support « poignée » 8, comme le montre la **figure 6**. Le report sélectif ou non des microcomposants 6 pourra ensuite être effectué sur un support final 9, comme le montre la **figure 7**.

Le support final 7 ou 9 peut être, par exemple, en silicium, en plastique, ou en verre, et il peut être souple ou rigide.

Après séparation et report de la couche superficielle 5, le reste du substrat fragilisé pourra être recyclé aussi bien en tant que substrat initial qu'en tant que support éventuel.

## Revendications

1. Procédé de fabrication, au moyen d'un substrat (1), de couches minces contenant des microcomposants (6), comprenant, pour chacune de ces couches minces, les étapes suivantes dans cet ordre :
a) l'implantation localisée d'au moins une espèce gazeuse dans ledit substrat (1) au droit d'une pluralité de zones d'implantation gazeuse définies à la surface du substrat (1), de manière à créer une pluralité de zones fragiles enterrées au voisinage de la profondeur d'implantation gazeuse,
b) la réalisation de microcomposants (6) dans la couche superficielle (5) du substrat (1) délimitée par lesdites zones fragiles enterrées, et
c) le détachement de ladite couche superficielle (5) du reste du substrat (1),
**caractérisé en ce que** ladite profondeur d'implantation et la géométrie desdites zones d'implantation gazeuse sont telles que l'étape b) est réalisée sans dégradation de la surface du substrat (1), et **en ce que** au moins un desdits microcomposants (6) est réalisé au moins partiellement au droit d'une zone qui n'a pas été implantée lors de l'étape a).

2. Procédé de fabrication selon la revendication 1, **caractérisé en ce que** certains au moins desdits microcomposants (6) sont réalisés à la fois au droit de zones qui ont été implantées et au droit de zones qui n'ont pas été implantées lors de l'étape a).

3. Procédé de fabrication selon la revendication 1 ou la revendication 2, **caractérisé en ce que** lesdites zones d'implantation sont définies par un masque (2) placé à la surface du substrat (1).

4. Procédé de fabrication selon l'une quelconque des revendications précédentes, **caractérisé en ce que** ladite espèce gazeuse est constituée par des ions hydrogène, ou par des ions d'au moins un gaz rare, ou par un mélange de ces ions.

5. Procédé de fabrication selon l'une quelconque des revendications précédentes, **caractérisé en ce que** la surface totale des zones d'implantation représente, approximativement, entre 1/3 et 5/6 de la surface du substrat (1).

6. Procédé de fabrication selon l'une quelconque des revendications précédentes, **caractérisé en ce qu'**une dimension linéaire des zones d'implantation est comprise, approximativement, entre 0,1 et 50 fois l'épaisseur de ladite couche superficielle (5).

7. Procédé de fabrication selon l'une quelconque des revendications précédentes, **caractérisé en ce qu'**il comprend, avant l'étape a) et/ou entre l'étape a) et l'étape b), au moins une étape supplémentaire d'introduction d'au moins une espèce gazeuse, cette au moins une introduction supplémentaire étant effectuée en l'absence de masque à la surface du substrat (1).

8. Procédé de fabrication selon l'une quelconque des revendications précédentes, **caractérisé en ce que**, avant ou au cours de l'étape b), on surfragilise la zone implantée.

9. Procédé de fabrication selon l'une quelconque des revendications précédentes, **caractérisé en ce qu'**il comprend, entre l'étape b) et l'étape c), une étape supplémentaire d'introduction d'au moins une espèce gazeuse.

10. Procédé de fabrication selon la revendication 9, **caractérisé en ce que** ladite introduction supplémentaire d'au moins une espèce gazeuse est effectuée à l'aide d'un masque définissant des zones d'implantation de cette au moins une espèce gazeuse.

11. Procédé de fabrication selon l'une quelconque des revendications précédentes, **caractérisé en ce que** ladite étape c) comporte un traitement thermique et/ou l'application de contraintes mécaniques.

12. Procédé de fabrication selon la revendication 11, **caractérisé en ce que** lesdites contraintes mécaniques comprennent l'utilisation d'un jet de fluide et/ou l'insertion d'une lame au niveau de la zone implantée, et/ou des contraintes en traction, cisaillement ou flexion appliquées au substrat (1).

13. Procédé de fabrication selon la revendication 11, **caractérisé en ce que** ledit traitement thermique comprend un chauffage au four et/ou un chauffage local et/ou un chauffage au laser.

14. Procédé de fabrication selon l'une quelconque des revendications 1 à 13, **caractérisé en ce que**, avant ou au cours de l'étape c), on applique sur le substrat (1) une surface (7) qui servira de support à ladite couche superficielle (5) après sa séparation du substrat (1).

15. Procédé de fabrication selon l'une quelconque des revendications 1 à 13, **caractérisé en ce que**, avant ou au cours de l'étape c), on applique sur le substrat (1) un support "poignée" (8), le report, sélectif ou non, des microcomposants (6) étant ensuite effectué sur un support final (9).

## Claims

1. A method for fabricating, by means of a substrate (1), thin layers containing microcomponents (6), including the following steps in this order for each of these thin layers:
a) localised implantation of at least one gaseous species in said substrate (1) in line with a plurality of gaseous implantation areas defined on the surface of the substrate (1), so as to create a plurality of weak areas buried near the gaseous implantation depth,
b) processing microcomponents (6) in the surface layer (5) of the substrate (1) delimited by said buried weak areas, and
c) detaching said surface layer (5) from the remainder of the substrate (1),
**characterised in that** said implantation depth and the geometry of said gaseous implantation areas are such that the surface of the substrate (1) is not degraded during step b), and **in that** at least one of said microcomponents (6) is formed at least partially in an area that was not implanted during step a).

2. A fabrication method according to claim 1, **characterised in that** at least some of said microcomponents (6) are formed at the same time in areas that were implanted and in areas that were not implanted during step a).

3. A fabrication method according to claim 1 or claim 2, **characterised in that** said implantation areas are defined by a mask (2) placed on the surface of the substrate (1).

4. A fabrication method according to any preceding claim, **characterised in that** said gaseous species comprises hydrogen ions, or ions of at least one rare gas, or a mixture of such ions.

5. A fabrication method according to any preceding claim, **characterised in that** the total surface area of the implantation areas represents from approximately 1/3 to approximately 5/6 of the surface area of the substrate (1).

6. A fabrication method according to any preceding claim, **characterised in that** a linear dimension of the implantation areas is from approximately 0.1 times to approximately 50 times the thickness of said surface layer (5).

7. A fabrication method according to any preceding claim, **characterised in that** it comprises, before the step a) and/or between the step a) and the step b), at least one supplementary step of introducing at least one gaseous species, this supplementary introduction being effected with no mask on the surface of the substrate (1).

8. A fabrication method according to any preceding claim, **characterised in that**, before or during the step b), the implanted area is overweakened.

9. A fabrication method according to any preceding claim, **characterised in that** it comprises, between the step b) and the step c), a supplementary step of introducing at least one gaseous species.

10. A fabrication method according to claim 9, **characterised in that** said supplementary introduction of at least one gaseous species is effected with the aid of a mask defining implantation areas of this at least one gaseous species.

11. A fabrication method according to any preceding claim, **characterised in that** said step c) includes heat treatment and/or applying mechanical stresses.

12. A fabrication method according to claim 11, **characterised in that** applying said mechanical stresses entails the use of a fluid jet and/or the insertion of a blade in the implanted area and/or applying traction, shear or blending stresses to the substrate (1).

13. A fabrication method according to claim 11, **characterised in that** said heat treatment comprises heating in a furnace and/or local heating and/or heating with a laser.

14. A fabrication method according to any of claims 1 to 13, **characterised in that** a surface (7) is applied to the substrate (1) before or during the step c) to serve as a support for said surface layer (5) after it is separated from the substrate (1).

15. A fabrication method according to any of claims 1 to 13, **characterised in that** a "handle" support (8) is applied to the substrate (1) before or during the step c), the microcomponents (6) then being selectively or non-selectively transferred to a final support (9).

## Patentansprüche

1. Verfahren zur Herstellung von Mikrobauelemente (6) enthaltenden Dünnschichten mit Hilfe eines Substrats, umfassend für jede dieser Dünnschichten die folgenden Schritte in dieser Reihenfolge:
a) die lokalisierte Implantation von mindestens einer gasförmigen Spezies in das Substrat (1) auf der Höhe einer Mehrzahl von auf der Oberfläche des Substrats (1) definierten Gasimplantationszonen, so dass eine Mehrzahl von versenkten fragilen Zonen in Nähe der Gasimplantationstiefe geschaffen wird,
b) die Herstellung von Mikrobauelementen (6) in der Oberflächenschicht (5) des Substrats (1), die von den versenkten fragilen Zonen begrenzt wird, und
c) das Abtrennen der Oberflächenschicht (5) vom Rest des Substrats (1),
**dadurch gekennzeichnet, dass** die Implantationstiefe und die Geometrie der Gasimplantationszonen so beschaffen sind, dass der Schritt b) ohne Beeinträchtigung der Oberfläche des Substrats (1) durchgeführt wird, und dass mindestens eines der Mikrobauelemente (6) mindestens teilweise auf Höhe einer Zone hergestellt wird, die im Schritt a) nicht implantiert wurde.

2. Herstellungsverfahren nach Anspruch 1, **dadurch gekennzeichnet, dass** mindestens manche dieser Mikrobauelemente (6) gleichzeitig auf Höhe von Zonen, die im Schritt a) implantiert wurden, und auf Höhe von Zonen, die nicht implantiert wurden, hergestellt werden.

3. Herstellungsverfahren nach Anspruch 1 oder Anspruch 2, **dadurch gekennzeichnet, dass** die Implantationszonen durch eine auf der Oberfläche des Substrats (1) angeordnete Maske (2) definiert werden.

4. Herstellungsverfahren nach einem der vorhergehenden Ansprüche, **dadurch gekennzeichnet, dass** die gasförmige Spezies aus Wasserstoffionen oder aus Ionen mindestens eines Edelgases oder aus einer Mischung dieser Ionen besteht.

5. Herstellungsverfahren nach einem der vorhergehenden Ansprüche, **dadurch gekennzeichnet, dass** die Gesamtfläche der Implantationszonen annähernd zwischen 1/3 und 5/6 der Fläche des Substrats (1) darstellt.

6. Herstellungsverfahren nach einem der vorhergehenden Ansprüche, **dadurch gekennzeichnet, dass** eine lineare Abmessung der Implantationszonen annähernd zwischen dem 0,1- und dem 50-fachen der Dicke der Oberflächenschicht (5) beträgt.

7. Herstellungsverfahren nach einem der vorhergehenden Ansprüche, **dadurch gekennzeichnet, dass** es vor dem Schritt a) und/oder zwischen dem Schritt a) und dem Schritt b) mindestens einen zusätzlichen Schritt der Einführung mindestens einer gasförmigen Spezies umfasst, wobei diese mindestens eine zusätzliche Einführung in Abwesenheit einer Maske auf der Oberfläche des Substrats (1) durchgeführt wird.

8. Herstellungsverfahren nach einem der vorhergehenden Ansprüche, **dadurch gekennzeichnet, dass** man vor oder während des Schritts b) die implantierte Zone überfragilisiert.

9. Herstellungsverfahren nach einem der vorhergehenden Ansprüche, **dadurch gekennzeichnet, dass** es zwischen dem Schritt b) und dem Schritt c) einen zusätzlichen Schritt der Einführung mindestens einer gasförmigen Spezies umfasst.

10. Herstellungsverfahren nach Anspruch 9, **dadurch gekennzeichnet, dass** die zusätzliche Einführung von mindestens einer gasförmigen Spezies mit Hilfe einer Maske durchgeführt wird, die Zonen der Implantation dieser mindestens einen gasförmigen Spezies definiert.

11. Herstellungsverfahren nach einem der vorhergehenden Ansprüche, **dadurch gekennzeichnet, dass** der Schritt c) eine Wärmebehandlung und/oder eine Ausübung von mechanischen Beanspruchungen umfasst.

12. Herstellungsverfahren nach Anspruch 11, **dadurch gekennzeichnet, dass** die mechanischen Beanspruchungen die Verwendung eines Fluidstrahls und/oder die Einführung einer Klinge auf Höhe der implantierten Zone und/ oder auf das Substrat ausgeübte Zug-, Scher- oder Biegebeanspruchungen umfassen.

13. Herstellungsverfahren nach Anspruch 11, **dadurch gekennzeichnet, dass** die Wärmebehandlung eine Erhitzung im Ofen und/oder eine lokale Erhitzung und/oder eine Lasererhitzung umfasst.

14. Herstellungsverfahren nach einem der Ansprüche 1 bis 13, **dadurch gekennzeichnet, dass** man vor oder während des Schritts c) an das Substrat (1) eine Fläche (7) anlegt, die als Träger für die Oberflächenschicht (5) nach ihrer Trennung vom Substrat (1) dient.

15. Herstellungsverfahren nach einem der Ansprüche 1 bis 13, **dadurch gekennzeichnet, dass** man vor oder während des Schritts c) auf das Substrat (1) einen "Griff"-Träger (8) aufbringt, wobei der selektive oder nicht selektive Übertrag der Mikrobauelemente (6) dann auf einen endgültigen Träger (9) vorgenommen wird.
